Europäisches Patentamt

European Patent Office

Office européen des brevets

(11) Publication number: **0 384 561**
**A2**

# EUROPEAN PATENT APPLICATION

(21) Application number: **90300280.6**

(22) Date of filing: **10.01.90**

(51) Int. Cl.5: **H01L 39/12, C04B 35/50**

(30) Priority: **24.02.89 US 315326**

(43) Date of publication of application:
**29.08.90 Bulletin 90/35**

(84) Designated Contracting States:
**DE FR GB**

(71) Applicant: **CORNING INCORPORATED**
**Houghton Park**
**Corning New York 14831(US)**

(72) Inventor: **Yu, Chyang John**
**2 Timber Lane**
**Painted Post New York(US)**

(74) Representative: **Smith, Sydney et al**
**Elkington and Fife Beacon House 113**
**Kingsway**
**London WC2B 6PP(GB)**

(54) **Noble metal substitution in REBCO superconductors.**

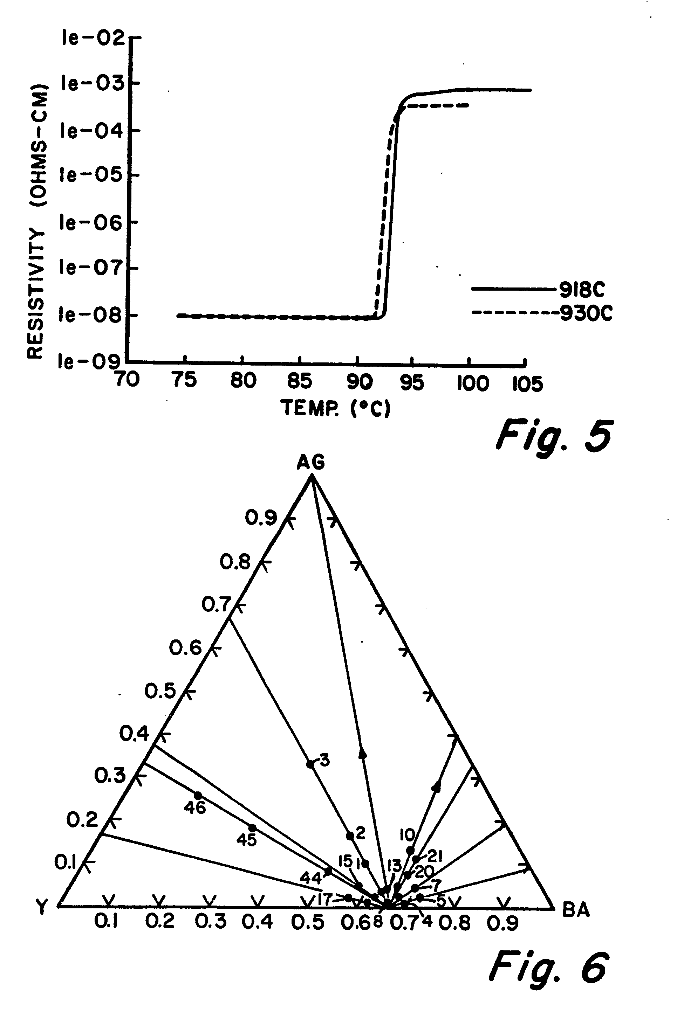

(57) Noble metals are mixed with the nominal stoichiometric composition of $REBa_2CU_3O_{7-x}$ ceramic superconducting body, in excess of the solubility limits of the noble metal in barium. The noble metals, in particular silver, substitute for barium in the superconducting phase, enhancing the volume percent of superconductivity. A ternary phase diagram of silver, barium and yttrium is shown in Fig 6.

Fig. 6

## NOBLE METAL SUBSTITUTION IN REBCO SUPERCONDUCTORS

### Background of the Invention

This invention is directed to the addition of noble metals to REBCO ceramic superconductors, also known as the 1,2,3 superconductor family. The nominal stoichiometric composition of this family is $REBa_2Cu_3O_{7-x}$, wherein RE is usually yttrium. It has been discovered by providing the ceramic batch with a noble metal, preferably silver, that there results an enhancement of the 1,2,3 superconducting phase of the ceramic. The noble metal participates as a scavenger taking unwanted species from the superconducting phase of the ceramic, and in substitution for barium in the crystalline superconducting phase of the ceramic structure.

The initial wave of excitement over the various ceramic superconductors has subsided over the past couple of months. The sobering reality that there are many hurdles yet to be overcome has beset the superconductor community, quieting expectations. The initial rare earth, barium, copper oxide discoveries were closely followed by what has come to be known as the BSCO, BiCaSrCuO, composition. Henceforth, optimization of the properties of the various ceramic compositions has been pursued in the hopes that the best compositions have been found, just hastily glued together.

The bulk of efforts since the initial find has been to substitute various species from the periodic chart which possess properties similar to those components in the inventive superconducting ceramics in the hopes of both improving and mimicking the already known superconductors.

The present invention differs from the above efforts. The manipulation of the atomic species, herein, is not an attempt to simply replace one rare earth for another or one alkaline earth for another. The present invention teaches that a noble metal, silver, may partially substitute for an alkaline earth metal in the 1,2,3 ceramic superconductor and provide properties unknown to that composition. Prior efforts have attempted to substitute silver for copper, as logic would dictate. (See "Effects of Ag/Cu Substitution in $YBa_2Cu_3O_7$ Superconductors", Mat. Res. Bull. Vol. 22, pp. 1581-1588, 1987) The substitution of noble metal for barium does not follow the same logic path since the two species are dissimilar.

The present invention discloses that the noble metal ion when present in the body provides an advantage to the 1,2,3 ceramic superconductor and when subsequently incorporated into the 1,2,3 ceramic superconducting phase, noble metal provides further advantages unknown to this art.

### Summary of the Invention

In the practice of this invention, noble metal ions are mixed with the nominal stoichiometric composition of the $REBa_2Cu_3O_{7-x}$ ceramic superconducting body, in excess of the solubility limits of noble metal in barium. For example, the preferable species, silver ion, is multifunctional; it substitutes for barium in the superconducting phase, acts as a flux, aids densification, and scavenges for anions thereby becoming incorporated in a companion nonsuperconducting phase. In the scavenger role, silver enhances the superconducting phase by enhancing the solid crystalline phase purity.

A 1,2,3 ceramic superconductor comprising the nominal stoichiometric formula $RENM_zK_kBa_{2-z}Cu_3O_{7-x}$ wherein RE is a rare earth metal species, wherein NM is a noble metal, z is greater than zero up to 1.2, K is an alkali such as potassium or rubidium, k equals up to .2, and x equals up to 2.4 is disclosed. The rare earth species is selected from the group Y, La, Ce, Pr, Nd, Sm, Eu, Gd, Tb, Dy, Er, and Yb or a combination thereof and therebetween. The noble metals are selected from Ag, Au, and some combination thereof. The ratio of the concentrations of [RE] + [NM] + [K] + [Ba] to [Cu] in $RENMKBaCU_3O_{7-x}$ is about 1.0 or essentially 1.0, in what is known as the A/B perovskite structure, to those skilled in this art. Further in particular, the solubility of silver in the above 1,2,3 ceramic superconductor in the Ba component is in a ratio of about .03.

The process, herein disclosed, for making the 1,2,3 superconductor lends itself, most preferably, to silver substitution for barium. The superconductor batch is mixed with silver oxide. As the batch is heated, the silver oxide partially reduces to silver metal. Additionally, free silver ions may be produced. It is speculated that the mobile silver ions interact within the forming superconductor phase and the silver metal interacts with the nonsuperconductor phase. It is further speculated that heat stimulates a silver/silver ion reduction-oxidation couple equilibrium in the presence of excess silver. Both species are then available for their advantageous interaction with the batch composition. Excess silver is defined as that amount of silver that exceeds the solubility limits of silver in barium wherein the ratio of Ag/Ba is about .03.

Onset transition temperatures from about 90K to 95K are observed. Superconductivities in the preferred embodiments have been observed as high as 90 volume percent at 67K.

## Brief Description of the Drawings

Fig. 1 is a magnetization versus field measurement at 65K of Example 1.

Fig. 2 is a magnetization versus field measurement at 65K of Example 2.

Fig. 3 is a magnetization versus field measurement at 65K of Example 3.

Fig. 4 is a magnetization versus temperature measurement under a constant magnetic field of Example 1.

Fig. 5 is a resistivity versus temperature measurement of Example 1.

Fig. 6 is a ternary diagram of barium, silver, and rare earth metal species.

## Description of the Preferred Embodiments

Generally, in the practice of this invention the following procedure was followed to produce the bodies of Examples 0-42. Those skilled in the ceramic arts will appreciate that this procedure may be varied from the description contained herein, to produce bodies of similar utility.

In Example 1, which is exemplary of Examples 0 through 25, 4.5 grams of $Y_2O_3$ (Apache Powder Co. Bensen, Az.), 1.4 grams of $Ag_2O$ (EM Science, Cherry Hill, NJ), 13.4 grams of $BaCO_3$ (FMC Corporation), and 9.5 grams of $CuO$ (Ceramic Color and Chemical Co., New Brighton, PA) were mixed in a 500 ml nalgene bottle. The powders were milled for approximately sixteen hours. The milled slurry was then dried in an oven at 80°C. The dried batch was calcined in air at 875°C for 10 hours. Examples 0 through 25 of Table 1 were batched by this process. The compositions in Table 1 are given in weight percent.

TABLE 1

| Example | Y/Ag/Ba/Cu | $Y_2O_3$ | $Ag_2O$ | $BaCO_3$ | CuO |
|---|---|---|---|---|---|
| 0 | 1/0/2/3 | 15.13 | 0 | 52.89 | 31.98 |
| 1 | 1.0/0.3/1.7/3 | 15.64 | 4.81 | 46.48 | 33.06 |
| 2 | 1.0/0.5/1.5/3 | 16.00 | 8.21 | 41.96 | 33.82 |
| 3 | 1.0/1.0/1.0/3 | 16.98 | 17.43 | 29.69 | 35.90 |
| 4 | 0.90/0.03/2.07/3 | 13.51 | 0.46 | 54.31 | 31.72 |
| 5 | 0.780/0.069/2.151/3 | 11.60 | 1.05 | 55.92 | 31.43 |
| 6 | 0.90/0.06/2.04/3 | 13.55 | 0.43 | 53.69 | 31.83 |
| 7 | 0.780/0.136/2.084/3 | 11.69 | 2.09 | 54.56 | 31.66 |
| 8 | 0.96/0.048/1.992/3 | 14.54 | 0.75 | 52.72 | 32.00 |
| 9 | 0.90/0.12/1.98/3 | 13.64 | 1.87 | 54.32 | 32.04 |
| 10 | 0.660/0.408/1.932/3 | 10.05 | 6.37 | 51.40 | 32.17 |
| 11 | 0.99/0.03/1.98/3 | 15.01 | 0.47 | 52.48 | 37.05 |
| 12 | 0.98/0.06/1.96/3 | 14.89 | 0.94 | 52.06 | 32.12 |
| 13 | 0.96/0.12/1.92/3 | 14.65 | 1.88 | 51.21 | 32.26 |
| 14 | 1.058/0.064/1.878/3 | 16.22 | 1.01 | 50.35 | 32.42 |
| 15 | 1.114/0.127/1.759/3 | 17.32 | 2.03 | 47.80 | 32.86 |
| 16 | 1.1/0.03/1.87/3 | 16.89 | 0.47 | 50.19 | 32.45 |
| 17 | 1.2/0.06/1.74/3 | 18.7 | 0.96 | 47.40 | 32.94 |
| 18 | 0.95/0.05/2.00/3 | 14.37 | 0.78 | 52.88 | 31.97 |
| 19 | 0.9/0.1/2.0/3 | 13.61 | 1.56 | 52.87 | 31.96 |
| 20 | 0.78/0.22/2.00/3 | 12.02 | 1.58 | 53.85 | 32.56 |
| 21 | 0.66/0.34/2.00/3 | 9.97 | 5.27 | 52.82 | 31.93 |
| 22 | 1.0/0.007/2.0/2.993 | 15.13 | 0.11 | 52.87 | 31.89 |
| 23 | 1.0/0.014/2.0/2.986 | 15.12 | 0.22 | 52.85 | 31.81 |
| 24 | 1.0/0.3/1.0/2.7 | 14.92 | 4.59 | 52.13 | 28.36 |
| 25 | 1.0/1.5/2.0/1.5 | 14.11 | 21.70 | 49.29 | 14.91 |

Examples 26 through 42, shown in Table 3, were made by a variation of the above process. In these examples, batch materials of the 1,2,3 superconductor were mixed and calcined. Calcining temperatures ranged up to 875°C for up to 10 hours. After calcining the hardened batch was crushed to about -325 mesh. Thereafter, certain uncalcined components were mixed with a specific calcined batched material. Table 2 shows the compositions in weight percent of the batched materials. Table 3 shows the compositions of Examples 26 through 42 in weight percent. Table 3 also shows examples of alkali ions such as rubidium and potassium substitutions. These were found to superconduct as well.

TABLE 2

| Batch | $Y_2O_3$ | $BaCO_3$ | CuO | $Ag_2O$ |
|---|---|---|---|---|
| B-1 | 15.12 | 52.84 | 31.95 | 0 |
| B-2 | 0 | 62.32 | 37.68 | 0 |
| B-3 | 0 | 59.98 | 38.17 | 1.85 |
| B-4 | 15.54 | 51.61 | 32.85 | 0 |
| B-5 | 16.39 | 50.86 | 32.75 | 0 |

4

## TABLE 3

| Example | Y/Ag/Ba/Cu | B-1 | $Y_2O_3$ | $Ag_2O$ | C-CuO |
|---|---|---|---|---|---|
| 00 | 1/0/2/3 | 100 | 0 | 0 | 0 |
| 26 | 1.0/0.02/1.98/3 | 99.13 | 0.17 | 0.35 | 0.36 |
| 27 | 1.0/0.06/1.94/3 | 97.35 | 0.51 | 1.05 | 1.08 |
| 28 | 1.0/0.1/1.9/3 | 95.59 | 0.86 | 1.75 | 1.80 |
| | Chemical Formula | B-2 | $Yb_2O_3$ | $Gd_2O_3$ | $Eu_2O_3$ |
| 29 | $YbBa_2Cu_3O_{7-x}$ | 76.28 | 23.72 | 0 | 0 |
| 30 | $GdBa_2Cu_3O_{7-x}$ | 77.75 | 0 | 22.25 | 0 |
| 31 | $EuBa_2Cu_3O_{7-x}$ | 78.26 | 0 | 0 | 21.74 |
| | | B-3 | $Yb_2O_3$ | $Gd_2O_3$ | $Eu_2O_3$ |
| 32 | $REAg_{0.1}Ba_{1.9}Cu_3O_{7-x}$ | 76.04 | 23.96 | 0 | 0 |
| 33 | $REAg_{0.1}Ba_{1.9}Cu_3O_{7-x}$ | 77.52 | 0 | 22.48 | 0 |
| 34 | $REAg_{0.1}Ba_{1.9}Cu_3O_{7-x}$ | 78.03 | 0 | 0 | 21.97 |

| | | B-4 | $Ag_2O$ | $Au_2O_3$ | $K_2CO_3$ | $Rb_2O_3$ |
|---|---|---|---|---|---|---|
| 35 | $YAg_{0.1}Ba_{1.9}Cu_3O_{7-x}$ | 98.43 | 1.57 | 0 | 0 | 0 |
| 36 | $YAu_{0.1}Ba_{1.9}Cu_3O_{7-x}$ | 97.05 | 0 | 2.95 | 0 | 0 |
| 37 | $YK_{0.1}Ba_{1.9}Cu_3O_{7-x}$ | 99.06 | 0 | 0 | 0.94 | 0 |
| 38 | $YRb_{0.1}Ba_{1.9}Cu_3O_{7-x}$ | 98.44 | 0 | 0 | 0 | 1.56 |

| | | B-5 | $Ag_2O$ | $Au_2O_3$ |
|---|---|---|---|---|
| 39 | $Y_{1.058}Ag_{0.064}Ba_{1.878}Cu_3O_{7-x}$ | 98.99 | 1.01 | 0 |
| 40 | $Y_{1.058}Au_{0.064}Ba_{1.878}Cu_3O_{7-x}$ | 98.09 | 0 | 1.91 |

| | | B-5 | $K_2CO_3$ | $Rb_2CO_3$ |
|---|---|---|---|---|
| 41 | $Y_{1.058}K_{0.064}Ba_{1.878}Cu_3O_{7-x}$ | 99.40 | 0.60 | 0 |
| 42 | $Y_{1.058}Rb_{0.064}Ba_{1.878}Cu_3O_{7-x}$ | 98.99 | 0 | 1.01 |

| | Y/Ag/Ba/Cu | $Y_2O_3$ | $Ag_2O$ | $BaCO_3$ | $CuO$ |
|---|---|---|---|---|---|
| 43 | 1.1/0.1/1.8/3 | 17.02 | 1.59 | 48.68 | 32.70 |
| 44 | 1.25/0.25/1.5/3 | 20.03 | 4.11 | 42.00 | 33.86 |
| 45 | 1.55/0.55/0.9/3 | 26.72 | 9.73 | 27.12 | 36.43 |
| 46 | 1.775/0.775/0.45/3 | 32.45 | 14.54 | 14.38 | 38.63 |

| | Y/La/Ba/Cu | B-1 | $Y_2O_3$ | $La_2(CO_3)_2$ | $CuO$ |
|---|---|---|---|---|---|
| 47 | 1.0/0.02/1.98/3 | 98.79 | 0.17 | 0.69 | 0.36 |
| 48 | 1.0/0.06/1.94/3 | 96.38 | 0.51 | 2.05 | 1.07 |
| 49 | 1.0/0.1/1.9/3 | 93.99 | 0.84 | 3.40 | 1.77 |

| | Y/Ag/La/Ba/Cu | B-1 | $Y_2O_3$ | $Ag_2O$ | $La_2(CO_3)_3$ | $CuO$ |
|---|---|---|---|---|---|---|
| 50 | 1/0.02/0.02/1.96/3 | 97.91 | 0.34 | 0.35 | 0.69 | 0.72 |

TABLE 4

| Example | % Superconductivity at 67K | Sintering T°C |
|---|---|---|
| 1 | 20 | 900 |
|  | 93 | 918 |
|  | 83 | 950 |
| 2 | 38 | 918 |
|  | 52 | 950 |
| 3 | 27 | 950 |
| 10 | 1.7 | 870 |
| 18 | 27 | 900 |
|  | 83 | 950 |
| 19 | 19 | 900 |
|  | 89 | 950 |
| 43 | 4.3 | 870 |
|  | 26 | 900 |
| 00 | 72 | 950 |
| 26 | 67 | 950 |
| 27 | 67 | 950 |
| 28 | 72 | 950 |
| 47 | 47 | 950 |
| 48 | 50 | 950 |
| 49 | 23 | 950 |
| 50 | 19 | 950 |

Table 4 shows some of the volume percent superconductivities observed. The volume percent varied as a function of sintering temperature and composition. Examples 47 through 50 were samples wherein $La_2(CO_3)_3$ had been substituted for barium in the sample from a stoichiometric range of .02,.02,.06, and .10, respectively. Ag was substituted in example 50, in addition to La, up to .02, stoichiometrically.

Sintering of the variously mixed Examples tracked the following procedure: Batches were placed in alumina boats and placed in a tube furnace adapted for a continuous flow of oxygen or air. The samples were brought up to about 850°C temperature at 300°C per hour. The temperature was held at this temperature for 2 hours. The samples were next heated to between about 870° to 950°C at 300°C per hour rate. The temperature was held within this range for 12 hours. Samples were next cooled to 500°C at 100°C per hour rate. Samples were then held at the 500°C temperature for 4 hours. The samples were then cooled to room temperature at about 100°C per hour.

X-ray diffraction analysis of some of the examples are shown in Table 5. Most of the samples analyzed exhibited a major phase of 1,2,3 superconductor.

TABLE 5

| Example | Sinter Temp(°C) | $YAg_zBa_{2-z}Cu_3O_{7-x}$ (101) | $Y_2BaCuO_5$ (131) | $BaCuO_2$ (600) | CuO (111) | Ag (111) |
|---|---|---|---|---|---|---|
| 1 | 900 | 100 | 5 | - | 5 | 5 |
|  | 918 | 100 | 9 | - | 5 | 3 |
|  | 950 | 100 | 10 | - | 5 | 4 |
| 2 | 870 | 100 | 20 | - | 15 | 21 |
|  | 900 | 100 | 11 | - | 8 | 12 |
|  | 918 | 100 | 11 | - | 10 | 9 |
|  | 950 | 100 | 13 | - | 9 | 5 |
| 3 | 870 | 100 | 37 | - | 26 | 69 |
|  | 950 | 100 | 100 | - | 100 | 60 |
| 10 | 870 | 100 | - | 68 | 13 | 22 |
|  | 900 | 100 | - | 21 | - | 7 |
| 18 | 900 | 100 | - | 11 | 0 | 0 |
|  | 950 | 100 | - | 3 | - | - |
| 19 | 900 | 100 | - | 16 | - | - |
|  | 950 | 100 | - | 4 | - | - |
| 43 | 870 | 100 | 12 | 21 | 7 | 2 |
|  | 900 | 100 | 7 | <1 | 3 | - |
|  | 918 | 100 | 6 | - | 2 | - |
| 44 | 870 | 100 | 20 | - | 9 | 6 |
|  | 900 | 100 | 27 | - | 11 | 5 |
|  | 918 | 100 | 42 | - | 20 | |
| 45 | 870 | 38 | 100 | - | 41 | 46 |
| 46 | 870 | - | 95 | - | 55 | 100 |

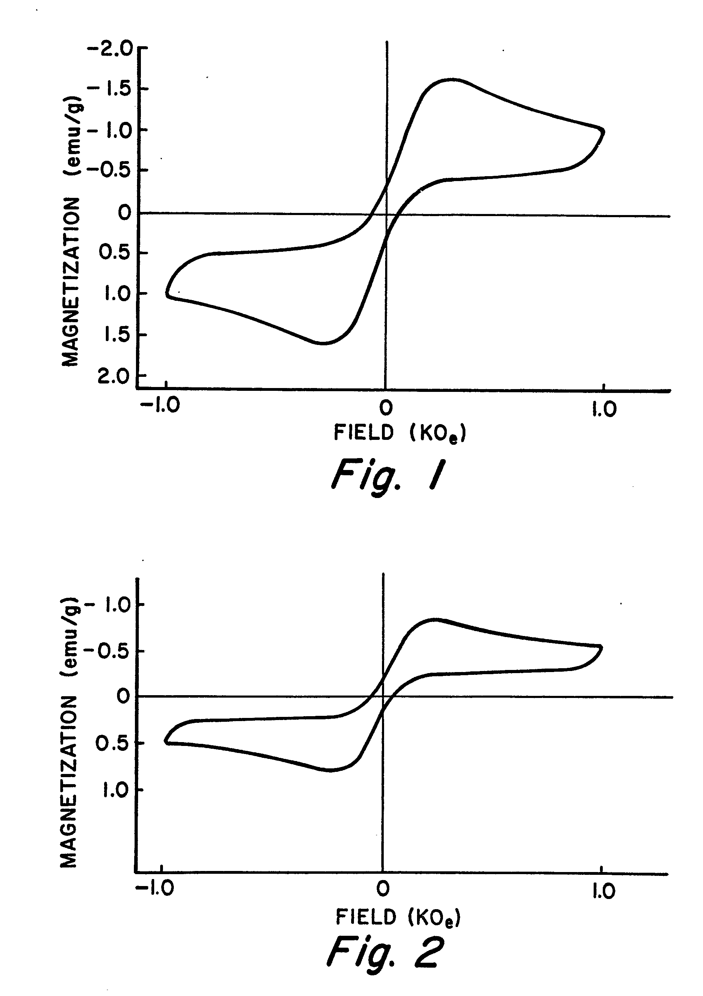

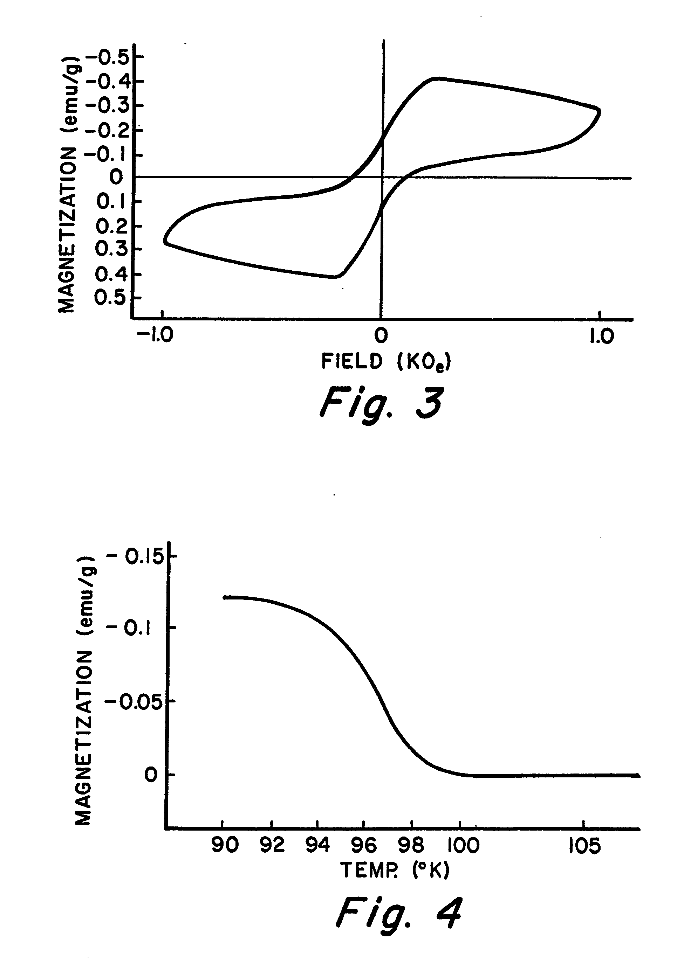

The magnetic moment hysteresis curve was measured with a magnetometer at about 65-67K. The percentage of super-conductivity was calculated from the initial slope of the hysteresis curve by assuming 100% Meissner effect for a perfect superconductor. The magnetic onset temperature of the sample was determined by recording the magnetic moment dependence as a function of temperature during cooling of the sample from about 100-105K to 67K. Figures 1, 2, and 3 show representative hysteresis curves for these measurements.

The four point probe resistivity method was used to take a measure of resistivity versus temperature. Gold stripes were evaporated on to a sample. Electrical contacts were made to copper wires with silver epoxy. A constant current source was used. The sample resistance was determined by measuring the voltage drop across the two inner voltage leads. A flow cryostat with temperature controller monitored the temperature chamber to about 4.2 to 300K. Figure 5 shows a representative resistivity versus temperature curve measured by the above process.

Figure 6 shows a ternary phase diagram of silver, barium, and yttrium which is representative of some the samples of this invention. The substitutions represented in Fig. 6 show silver replacing barium, yttrium is held constant. The behavior of the silver for barium substitution in the range of compositions within the matrix indicates the generality of this substitution phenomena in the 1,2,3 superconducting phase.

These compositions were formulated by keeping the A/B ratio equal to approximately 1.0 for the perovskite structured cuprates. The copper composition, or B portion of the ratio, was kept constant relative to the A portion of the ratio. Only the A portion of the ratio was adjusted among the partial components for summation to the total A portion of the ratio. In this ratio the A site is for RE, Ba, and NM, and the B site for copper. When the alkali ions are substituted, they too can partially substitute within the A portion of the A/B ratio.

**Claims**

1. A 1,2,3 ceramic superconductor comprising the nominal stoichiometric formula $RENM_zK_kBa_{2-z}Cu_3O_{7-x}$, wherein RE is a rare earth metal species, wherein NM is a noble metal, z is greater than zero up to 1.2, wherein K is an alkali ion, k equals up to .2, x equals up to 2.4, wherein excess noble metal is added to said nominal composition.

2. A 1,2,3 ceramic superconductor comprising the components of nominal stoichiometric formula $RENMKBaCU_3O_{7-x}$, wherein RE is a rare earth metal species, NM is anoble metal, K is an alkali [RE] + [NM] + [Ba] + [K] to [Cu] concentration equals about 1.0.

3. The 1,2,3 ceramic superconductor of claim 1 or 2 wherein said rare earth species is selected from the group consisting of Y, La, Ce, Pr, Nd, Sm, Eu, Gd, Tb, Dy, Er, Yb, a combination thereto and therebetween.

4. A 1,2,3 ceramic superconductor comprising a nominal stoichiometric formula $REAg_zBa_{2-z}Cu_3O_{7-x}$, wherein RE is a rare earth metal species, z is greater than 0 up to 1.2, x equals up to 2.4, and the solubility of silver in barium is maintained in a ratio up to .03.

5. The 1,2,3 ceramic superconductor of claim 2 wherein the volume percent superconductivity ranges between greater than 0 and up to 90 percent.

6. The 1,2,3 ceramic superconductor of claim 1 wherein said excess noble metal is in a second nonsuperconducting phase.

7. The 1,2,3 ceramic superconductor of claim 1 wherein said excess noble metal is a scavenger.

8. The 1,2,3 ceramic superconductor of claim 1 or 2 wherein said noble metal is silver, gold or a combination thereof.

9. The 1,2,3 ceramic superconductor of claim 1 or 2 wherein said alkali ion is potassium, rubidium or a combination thereof.

Fig. 1

Fig. 2

*Fig. 3*

*Fig. 4*

Fig. 5

Fig. 6